# EUROPÄISCHE PATENTANMELDUNG

(11) **EP 1 148 646 A1**
(43) Veröffentlichungstag der Anmeldung: **24.10.2001**
(21) Anmeldenummer: 00108512.5
(22) Anmeldetag: 19.04.2000
(51) Int. Cl.: H03K 5/135, H04L 7/033

(54) **Verfahren zur Optimierung der Abtastung digitaler Signalwellen**

(71) Anmelder: TOSHIBA Electronics Europe GmbH, 40549 Düsseldorf (DE)
(72) Erfinder: Berns, Jan Peter, 47877 Willich (DE); Klein, Axel, 40667 Meerbusch (DE); Frochte, Marc, 40210 Düsseldorf (DE); Zimmermann, Christoph, 46519 Alpen (DE)
(74) Vertreter: Stenger, Watzke & Ring Patentanwälte

(57) **Zusammenfassung**

Der vorliegenden Erfindung liegt die Aufgabe zugrunde, ein Verfahren bereitzustellen, mit welchem Fehler auch bei sehr hohen Abtastgeschwindigkeiten weitestgehend vermieden werden können. Zur technischen Lösung dieser Aufgabe wird mit der Erfindung vorgeschlagen ein Verfahren zur Optimierung des Abtastzeitpunktes einer durch wenigstens eine Flanke einer Clock-Frequenz-Schwingung gesteuerten Abtastschaltung für hochfrequente digitale Bitfolgen repräsentierende Signalwellen, wobei kontinuierlich die relative Lage der wenigstens einen Flanke der Clockfrequenzschwingung zur Mitte zwischen den zwei Flanken der digitalen Signale ermittelt und bei Abweichungen die Phase der Clockfrequenzschwingung in Richtung der Mitte verschoben wird.

## Beschreibung

Die vorliegende Erfindung betrifft ein Verfahren zur Optimierung des Abtastzeitpunktes einer Abtastschaltung für hochfrequente digitale Bitfolgen repräsentierende Signalwellen, welche durch wenigstens eine Flanke einer Clock-Frequenz-Schwingung gesteuert wird.

Die Abtastung hochfrequenter digitaler Signalwellen ist an sich bekannt. Derartige hochfrequente Bitfolgen werden durch modernste Übertragungstechnik möglich, wobei beispielsweise in Glasfaserleitungen inzwischen bis zu 10 Gbit standardgemäß transportiert werden können. In großen Netzwerken werden über Schnellschnittstellen diese hochfrequenten Datenfolgen auf weiterverarbeitende Systeme umgesetzt, die jedoch derartige Geschwindigkeiten nicht seriell abarbeiten können. Anwendungsbereiche sind beispielsweise die im Bereich der Telekommunikationsindustrie eingesetzten Datenverarbeitungsanlagen. In diesen wird die Verarbeitung der Datenströme beispielsweise durch digitale Signalverarbeitung auf Application Specific Integrated Circuits (ASIC), die in der Regel mit CMOS Bausteinen realisiert sind, durchgeführt.

Die über Glasfaserleitungen herangeführten hochfrequenten Datenfolgen werden auf CMOS-Bausteine umgesetzt. Zu diesem Zweck werden üblicherweise GaAs- oder Bipolar-Demultiplexer eingesetzt, wobei es sich um sehr teuere und energieintensive Bausteine handelt. Diese setzen die hochfrequenten seriellen Datenströme in eine entsprechende Anzahl von Kanälen mit niedrigerer Datenfrequenz um, welche dann in die CMOS-Bausteine eingeleitet und dort abgetastet werden. Die Abtastfrequenz findet ihre Grenzen in den sehr niedrig angesetzten zulässigen Fehlerraten, die etwa bei 10⁻¹² festgeschrieben sind. Zum Abtasten werden im Stand der Technik beispielsweise in den CMOS-IC-Bausteinen integrierte Flip-Flop-Schaltungen und dergleichen eingesetzt. Diese werden mit einem von einem Taktsignal-Generator erzeugten Abtast-Takt betrieben. Da jedoch durch die technischen Gegebenheiten, Störungen oder Schaltungsaufbau Verschiebungen in Bezug auf die Signallaufzeit auftreten, "jitter" genannt, ergeben sich bei hohen Abtastgeschwindigkeiten Fehler, die in erster Linie daraus resultieren, daß zum Abtastzeitpunkt ein flankennaher Bereich der Signalwelle abgetastet wird, so daß das Signal nicht sauber interpretierbar ist, woraus sich eine entsprechende Fehlerrate ergibt. Das Vorliegen von Frequenzunterschieden zwischen Datensignalen und Clock-Taktsignalen wird als "Wander" bezeichnet.

Ausgehend vom vorbeschriebenen Stand der Technik liegt der vorliegenden Erfindung die **Aufgabe** zugrunde, ein Verfahren bereitzustellen, mit welchem Fehler auch bei sehr hohen Abtastgeschwindigkeiten weitestgehend vermieden werden können.

Zur technischen **Lösung** dieser Aufgabe wird mit der Erfindung vorgeschlagen ein Verfahren zur Optimierung des Abtastzeitpunktes einer durch wenigstens eine Flanke einer Clock-Frequenz-Schwingung gesteuerten Abtastschaltung für hochfrequente digitale Bitfolgen repräsentierende Signalwellen, wobei kontinuierlich die relative Lage der wenigstens einen Flanke der Clockfrequenzschwingung zur Mitte zwischen den zwei Flanken der digitalen Signale ermittelt und bei Abweichungen die Phase der Clockfrequenzschwingung in Richtung der Mitte verschoben wird.

Um die Abtastgeschwindigkeit erhöhen zu können, wird mit der Erfindung vorgeschlagen, dafür zu sorgen, daß der Abtastzeitpunkt so gewählt ist, daß die Signalwelle in einem Bereich stabiler Signallage abgetastet wird. Dieser Bereich ist die Mitte eines digitalen Signals zwischen den zwei Flanken. Der besondere Vorteil der vorliegenden Erfindung besteht darin, zu dem Zwecke der Erreichung des vorgeschlagenen Abtastzeitpunktes die Phase der Clock-Frequenz-Schwingung zu verschieben, um auf diese Weise somit die Abtastfrequenz auf die Signalbereichsmitte abzustimmen. Diese neuartige erfindungsgemäße Vorgehensweise bewirkt, daß keinerlei Limits für die Anforderungen an das "Wander"-Phänomen gestellt werden müssen. Insbesondere kann durch die erfindungsgemäße Vorgehensweise die Abtastrate erheblich erhöht werden, so daß sich Frequenzen von 622 Mbit und sogar von 1,25 Gbit und darüber standardgemäß realisieren lassen.

Mit der Erfindung wird in vorteilhafter Weise vorgeschlagen, daß zur Phasenverschiebung der Clock-Frequenz-Schwingung eine Auswahl aus einer gegebenen Anzahl gleichzeitig angebotener Phasenschwingungen getroffen wird. Es werden also einem Controller zeitgleich gemäß einem vorteilhaften Vorschlag der Erfindung phasenverschobene Taktsignale zur Verfügung gestellt, die jeweils um einen gleichen Abstand relativ zueinander phasenverschoben sind. Über eine Phasenauswahleinheit (Phase-Select-Unit/PSU) wird die entsprechend geeignete Phasenschwingung ausgewählt und nach diesem Takt abgetastet.

Zur Ermittlung der Mitte eines Datensignals wird in vorteilhafter Weise die Signalwelle einer Meßstrecke zugeführt, wo sie an einer gegebenen Anzahl von Meßpunkten synchron abgetastet wird, und der jeweilige digitale Zustandswert einer Abtaststelle ermittelt wird. Aus diesen Abtastvorgängen lassen sich Bereiche stabiler Signallagen ermitteln und die Phase der Clock-Frequenz-Schwingung kann Richtung der Mitte dieses Bereiches stabiler Signallage eingestellt bzw. korrigiert werden.

Mit Vorteil wird mit der Erfindung vorgeschlagen, die Meßstrecke durch in Reihe geschaltete Verzögerungselemente auszubilden, wobei die digitalen Zustandswerte der Signalwelle synchron hinter jedem der Verzögerungselemente abgetastet werden. Man spricht bei dieser Vorgehensweise vom sogenannten Oversamplen. Das Ergebnis der kontinuierlich wiederholten Abtastvorgänge ist ein konkretes Bild der Zustandslagen der Signalwelle und der Position der Flanken. Für die Phasenkorrektur der Abtastfrequenz, also der Clock-Frequenz, werden jeweils paarweise alle benachbart abgetasteten Zustandswerte logisch miteinander verglichen. Sind die Zustandswerte gleich, wird beispielsweise je nach logischem Vergleich eine null als Ergebnis Bit gesetzt, sind die benachbarten Zustandswerte ungleich, wird eine eins gesetzt. Eine Vielzahl synchron stattfindender Zustandswertevergleiche ergeben also ein Signal aus einer Anzahl von Vergleichs-Ergebnis-Bits. Diese Ergebnissignale werden mit den Ergebnissignalen aufeinanderfolgenden Abtastvorgänge bis zur Sättigung von 1 aufsummiert. Daraus ergeben sich die Positionen der Bereich stabiler Signallagen. Die Lage dieser Bereiche stabiler Signallage kann in Bezug auf einen der Abtastpunkte der Verzögerungsschaltung gesetzt werden, welcher als Position für die eigentliche Signalabtastung, das Datum, festgelegt wurde. Somit ergibt sich ein Maß für die relative Lage des Abtastpunktes zur Mitte des Bereichs stabiler Signallage, so daß daraus direkt auf Richtung und Notwendigkeit der Phasenverschiebung für die Abtast-Taktfrequenz geschlossen werden kann.

Durch die erfindungsgemäße Vorgehensweise werden also die Flankenpositionen ermittelt. Die Länge der Verzögerungskette wird so ausgelegt, daß mindestens im eingeschwungenen Zustand eine Flanke an der Eingangsseite der Datenverzögerungskette und einem Abtastzeitraum später an der Ausgangsseite detektiert wird. Als Verzögerungsglieder werden gemäß einem vorteilhaften Vorschlag der Erfindung entweder Inverter oder gemäß einem alternativen Vorschlag der Erfindung Buffer eingesetzt. Um mindestens zwei Flanken zu erfassen, werden beispielsweise 32 Verzögerungsglieder in Reihe geschaltet, so daß sich 33 Abtastwerte während des Oversampling-Vorganges ergeben, wenn auch vor dem ersten Verzögerungsglied abgetastet wird. Diese sind entweder 0 oder 1. Durch den paarweisen logischen Vergleich ergeben sich somit 32 logische Vergleichsergebnisse, die null sind, wo die Werte gleich sind bzw. eins, wo die benachbarten Abtastwerte unterschiedlich sind. Somit kann die Lage der Flanke exakt bestimmt werden. Da die Flanken durch das Verzögerungsfeld wandern, werden durch aufeinanderfolgende Abtastvorgänge und das Aufsummieren der logischen Vergleichsergebnisse bis zur Sättigung von 1 somit Wertefolgen aus 32 Werten erzeugt, bei denen im mittleren Bereich ein als "Datenauge" bezeichneter Bereich stabiler Signallage erfaßt wird. Nach erfolgter Nachregelung, d. h. Phasenverschiebung der Clock-Frequenz, wird diese Aufsummierung auf 0 zurückgesetzt.

Gemäß einem vorteilhaften Vorschlag der Erfindung erfolgt das Aufsummieren hinter XOR/XNOR-Gattern in einem Rechenwerk. Das Ermitteln der daraus resultierenden Phasenverschiebung erfolgt in einem weiteren Rechenwerk (Controller).

Die Erzeugung der Taktfrequenz erfolgt gemäß einem vorteilhaften Vorschlag der Erfindung mittels eines PLL, der beispielsweise acht phasenverschobene Taktsignale aus einem Referenz-Clock-Signal erzeugt. Weiterhin werden gegebenenfalls die acht phasenverschobenen Taktsignale in der PSU invertiert, so daß sich insgesamt 16 phasenverschobene Taktsignale ergeben würden. Wird beispielsweise eine Abtastrate von 622 Mbit angewandt, kann ein PLL aus einer 78 MHz Referenzfrequenz acht phasenverschobene 622 MHz Signale erzeugen, mit Invertierung 16, die jeweils mit einem Abstand von 100 ps zueinander aufweisen. Diese werden einer PSU zugeführt, welche die ausgewählte Phase der als Verzögerungsschaltung ausgelegten Meßstrecke zuführt. Diese wiederum nimmt die seriellen Daten auf, verzögert und oversampled diese und übermittelt die Ergebnisse einem Controller, der wiederum das Phasenauswahlsignal ermittelt und an die PSU leitet. Anstelle eines einzigen ausgewählten Taktfrequenzsignals können auch mehrere benachbarte Taktfrequenzsignale ausgewählt und zusammengefaßt werden, beispielsweise zwei bis drei benachbarte Signale, um Fehler zu vermeiden, wobei man von Phasenmixing spricht.

Zusätzlich zu den angebotenen Phasen können im Bedarfsfalle weitere Phasen generiert werden. Daraus ergibt sich vorteilhafterweise eine Energieeinsparung.

Auf diese Weise wird sichergestellt, daß jeweils die Abtastung zu einem Zeitpunkt erfolgt, wo ein Bereich stabiler Signallage vorliegt, bzw. zum Abtastzeitpunkt an der Abtastposition jeweils ein solcher Bereich stabiler Signallage vorliegt. Dadurch werden Fehler bei der Abtastung vermieden und es können sehr hohe Abtastfrequenzen realisiert werden. So können beispielsweise 622 Mbit Abtastungen erfolgen, wenn zum Zeitpunkt der positiven Flanke des Taktsignals abgetastet wird, und es können 1,25 Gbit abgetastet werden, wenn sowohl zum Zeitpunkt der positiven als auch zum Zeitpunkt der negativen Flanke des Abtastsignals abgetastet wird, ohne daß deshalb die vom PLL gelieferten Frequenz verändert werden muß.

Die gesamte zur Durchführung des Verfahrens erforderliche Anordnung in Form von PLL, der Einheit zur Erzeugung der phasenverschobenen Taktfrequenzen, der PSU, der Verzögerungsschaltung und dem Verzögerungscontroller können auf einem IC integriert werden. Ein Anwendungsbereich sind die eingangs beschriebenen Schnellschnittstellen von Datennetzwerken, insbesondere die Umsetzung von über Glasfaser bereitgestellten Datenströmen in CMOS-Bausteine, wie dies beispielsweise im Bereich der Telekommunikationsindustrie erforderlich ist, oder auch sogenannte "schnelle Busstrukturen" im Bereich der PC.

Mit der Erfindung wird ein neuartiges Verfahren vorgeschlagen, mit welchem Fehler bei der Datenabtastung auch bei sehr hohen Abtastfrequenzen vermeidbar sind, so daß Schnellschnittstellen mit gegenüber dem Stand der Technik bedeutend höheren Frequenzen betrieben werden können. So sind Frequenzen ab 622 MHz bzw. 622 Mbit aber auch höhere Frequenzen in Bereichen von 1,25 Gbit und darüber standardgemäß realisierbar. Es werden auch sehr viel höhere Frequenzen unter Anwendung des erfindungsgemäßen Verfahrens realisierbar sein. Dabei ist wesentlich die gleichzeitige Bereitstellung mehrerer verfügbarer Phase einer Taktfrequenz und die Verschiebung der Phasen der Taktfrequenz durch Auswahl einer der gleichzeitig bereitgestellten Phasen, um den Abtastzeitpunkt auf die Mitte eines Bereiches stabiler Signallage zu legen. Diese neuartige Vorgehensweise eröffnet neuartige Perspektiven im Hinblick auf Schnellschnittstellengeschwindigkeiten.

Die Erfindung hält auch eine Vorrichtung zur Durchführung des Verfahrens bereit, welche einen PLL zur Erzeugung der Taktfrequenzphasen, eine PSU, eine Verzögerungsschaltung und einen Verzögerungscontroller umfaßt. Die Verzögerungsschaltung ist beispielsweise aufgebaut aus hintereinander geschalteten Inverter-Gliedern oder hintereinander geschalteten Buffer-Gliedern. Zur Erzeugung der invertierten Taktfrequenzen können herkömmliche Inverterschaltungen verwendet werden. Die Logikbausteine sind je nach Verzögerungsbausteine "XNOR"-Gatter bei der Verwendung von Invertergliedern bzw. "XOR"-Gatter bei der Verwendung von Buffern. Für die Aufsummierung und die Ermittlung der Phasenverschiebung wird ein Rechenwerk vorgeschlagen. Die gesamte Vorrichtung kann in einem IC integriert werden, wobei der Chip hierfür nicht weiter vergrößert werden muß.

Weitere Vorteile und Merkmale der Erfindung ergeben sich aus der folgenden Beschreibung anhand der Figuren. Dabei zeigen:
- Fig. 1: eine schematische Darstellung des Aufbaus einer Vorrichtung zur Durchführung des erfindungsgemäßen Verfahrens;
- Fig. 2: eine beispielhafte Darstellung eines Ausschnitts aus einer Verzögerungsschaltung und einem Ausschnitt aus einer Signalwelle;
- Fig. 3: eine Darstellung eines Ausschnitts aus einer Verzögerungsschaltung mit der dazugehörigen Vergleicherschaltung;
- Fig. 4: eine alternative Ausführungsform gemäß Fig. 3 und
- Fig. 5: eine Darstellung eines Ausschnitts einer Abtastschaltung.

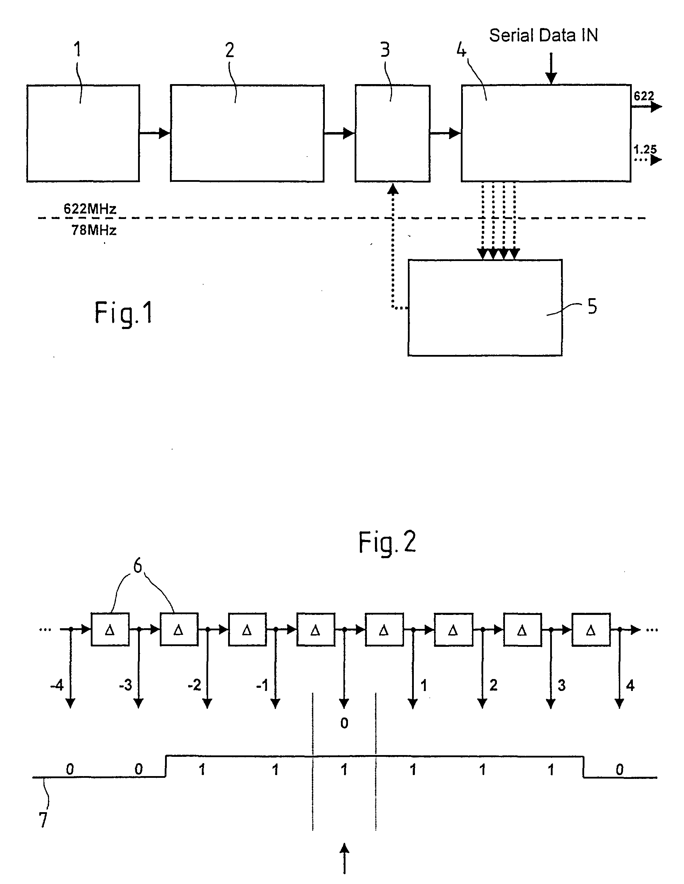

Fig. 1 zeigt schematisch ein Ausführungsbeispiel für einen Aufbau einer erfindungsgemäßen Vorrichtung bestehend aus einem PLL, der beispielsweise eine Taktfrequenz von 622 MHz erzeugt, welche in der Phase-Distribution-Einheit auf acht phasenverschobene Signale umgesetzt wird, die jeweils 100 ps voneinander beabstandet sind. Zugleich können diese acht Signale invertiert werden, woraus sich 16 gleich beabstandete phasenverschobene Signale ergeben. Über eine Phasenauswahleinheit 3 wird die ausgewählte Phase als Abtastsignal für die Datenabtastschaltung, den sogenannten Data Capture Block, genutzt. In diese Schaltung werden die seriellen Daten aufgegeben und über eine Verzögerungsschaltung geführt, wobei ein Abtastpunkt der Verzögerungsschaltung zugleich auch den eigentlichen Abtastpunkt für den Datenwert bildet. Über die Verzögerungsschaltung und die anschließende Analyse durch logischen Vergleich benachbarter Abtastwerte und die Aufsummierung wird die Flankenlage erkannt, so daß in einem Delay Controller 5 die Phasenverschiebung der Abtastfrequenz in Richtung der Mitte des Bereichs stabiler Datenlage ermittelt werden kann. Dabei handelt es sich im beschriebenen Ausführungsbeispiel um einen digitalen Controller der bei 78 MHz arbeitet. Diese gibt auf die Phase-Select-Unit 3 das Auswahlsignal für die jeweils gewünschte Phase der Abtastfrequenz. Der Ausgang des Data Capture Blocks sind die Daten bei 622 MHz, wenn jeweils die positive Flanke der Abtastfrequenz zum Auslesen verwendet wird, bzw. 1,25 Gbit, wenn sowohl die positive als auch die negative Flanke verwendet werden. Dabei werden die Daten in parallelen Kanälen, beispielsweise 8 x 78 Mbit bzw. 16 x 78 Mbit ausgegeben.

Fig. 2 zeigt einen Ausschnitt aus der Verzögerungsschaltung, Data Delay Line, die aus in Reihe geschalteten Buffergliedern 6 besteht. Durch die Verzögerungsschaltung wird die Datensignalwelle 7 geführt, welche auf null liegende Daten und auf eins liegende Daten mit dazwischen liegenden Flanken umfaßt. Zwischen den Buffern 6 liegend die Abtastpunkte, wobei ein Abtastpunkt als Data Capture Punkt definiert ist. Dieser ist in Fig. 2 mit null bezeichnet und liegt im mittleren Bereich des Signales, so daß eine fehlerfreie Signalabtastung möglich ist.

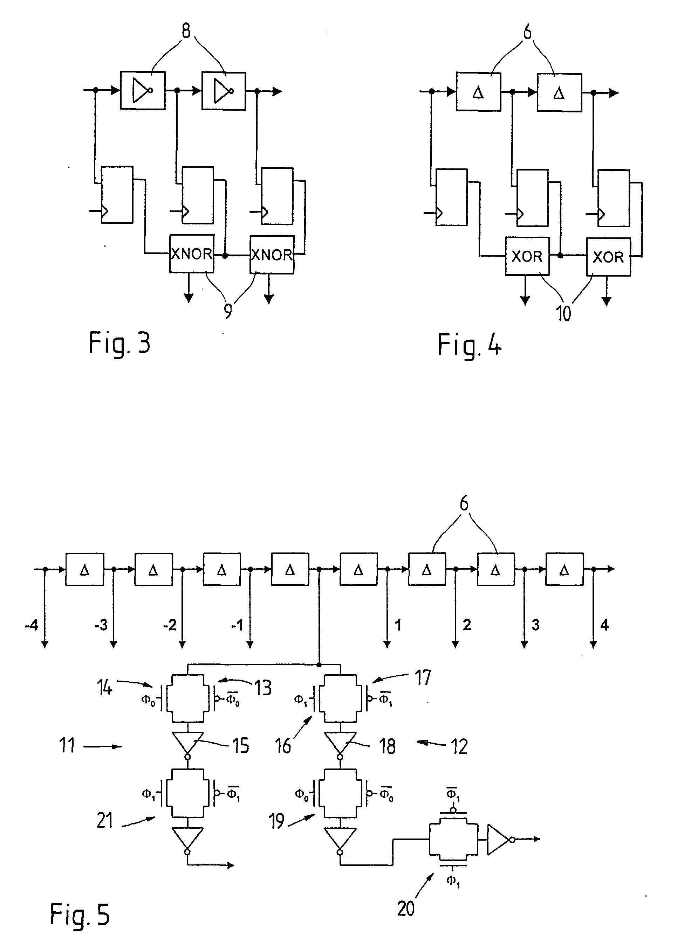

Fig. 3 zeigt einen Ausschnitt aus einer Datenverzögerungsschaltung, wobei Inverterglieder 8 in Reihe geschaltet sind. Die von den Abtastpunkten abgetasteten Daten werden über "XNOR"-Gatter logisch verglichen. Bei dem in Fig. 4 gezeigten Ausführungsbeispiel besteht die Verzögerungsschaltung aus Buffern 6 und die abgetasteten Daten werden über "XOR"-Gatter verglichen. Die Vergleichsergebnisse werden jeweils zum Zähler (nicht gezeigt) geführt.

An dem als Data Capture Punkt definierten Abtastpunkt kann ein wie in Fig. 4 gezeigter Aufbau verwendet werden. Es werden sogenannte Master-Slave-Flip-Flops verwendet, jeweils bestehend aus einem "Transmission-Gate" und einem Inverter. Der linke Teil 11 dieser Master-Slave-Schaltung wird verwendet bei 622 Mbit Abtastrate. Es werden zunächst bei steigender Flanke die Werte durch das erste Master-Flip-Flop 13, 14, 15 geführt und bei der negativen Flanke von der zweiten Slave-Flip-Flop 21 Anordnung ausgegeben. Bei 1,25 Mbit werden beide Zweige verwendet, wobei bei positiver Flanke der Abtastfrequenz zunächst ein Wert in den linken Zweig 11 geführt, wo der abgetastete Wert über die beiden Transistoren 13, 14 und den Inverter 15 geführt wird. Bei negativer Flanke der Abtastfrequenz wird der Wert im linken Zweig 11 in das nächste Slave-Flip-Flop 21 geführt und ausgegeben, gleichzeitig wird in den rechten Zweig 12 ein neu ausgelesener Wert in den aus den Transistoren 16, 17 und den Inverter 18 aufgebauten Master-Flip-Flop geführt. Der rechte Zweig 12 braucht somit zwei Slave-Flip-Flops 19 und 20.

Die beschriebenen Ausführungsbeispiele dienen nur der Erläuterung und sind nicht beschränkend.

### Bezugszeichenliste

- 1: PLL
- 2: Phase Distribution
- 3: Phase Select
- 4: Data Delay Line/Data Capture Block
- 5: Delay Controller
- 6: Buffer
- 7: Signalwelle
- 8: Inverter
- 9: XNOR-Gatter
- 10: XOR-Gatter
- 11: Master-Slave-Flip-Flop
- 12: Master-Slave-Flip-Flop
- 13: Transistor
- 14: Transistor
- 15: Inverter
- 16: Transistor
- 17: Transistor
- 18: Inverter
- 19: Slave-Flip-Flop
- 20: Slave-Flip-Flop
- 21: Slave-Flip-Flop

## Patentansprüche

1. Verfahren zur Optimierung des Abtastzeitpunktes einer durch wenigstens eine Flanke einer Clock-Frequenz-Schwingung gesteuerten Abtastschaltung für hochfrequente digitale Bitfolgen repräsentierende Signalwellen, wobei kontinuierlich die relative Lage der wenigstens einen Flanke der Clockfrequenzschwingung zur Mitte zwischen den zwei Flanken der digitalen Signale ermittelt und bei Abweichungen die Phase der Clockfrequenzschwingung in Richtung der Mitte verschoben wird.

2. Verfahren nach Anspruch 1, **dadurch gekennzeichnet, daß** zur Phasenverschiebung der Clockfrequenzschwingung die jeweils geeignete Phase aus einer von einer Clock-Frequenz-Generatorschaltung gleichzeitig angebotenen Anzahl von Phasen-Schwingungen ausgewählt wird.

3. Verfahren nach einem der vorhergehenden Ansprüche, das zur Ermittlung der Mitte zwischen den zwei Flanken der digitalen Signale die Signalwelle durch eine Meßstrecke geführt wird, in welcher an einer gegebenen Anzahl von Meßpunkten der jeweilige digitale Zustandswert der Signalwelle festgestellt und ein Bereich stabiler Signallage ermittelt wird.

4. Verfahren nach Anspruch 3, **dadurch gekennzeichnet, daß** die Meßstrecke aus hintereinander geschalteten Verzögerungselementen gebildet wird, wobei die digitalen Zustandswerte der Signalwelle synchron hinter jedem der Verzögerungselemente abgetastet werden.

5. Verfahren nach einem der vorhergehenden Ansprüche, **dadurch gekennzeichnet, daß** jeweils zwei benachbart abgetastete Zustandswerte logisch verglichen und die Ergebnisse aufeinanderfolgender Abtastvorgänge und logischer Vergleiche bis zur Sättigung von 1 aufsummiert werden.

6. Verfahren nach Anspruch 5, **dadurch gekennzeichnet, daß** die Aufsummierung und die daraus resultierende Phasenverschiebung in einem digitalen Rechenwerk erfolgen.

7. Verfahren nach einem der vorhergehenden Ansprüche, **dadurch gekennzeichnet, daß** als Clock-Frequenz-Generator eine PLL verwendet wird.

8. Verfahren nach einem der vorhergehenden Ansprüche, **dadurch gekennzeichnet, daß** acht Taktsignale die zusätzlich über eine Inverterkette über einen CMOS-Baustein verteilt werden, an Leitungen mit einer Phasen-Selction-Unit bereitgestellt werden.

9. Verfahren nach einem der vorhergehenden Ansprüche, **dadurch gekennzeichnet, daß** die eigentliche Signalabtastung jeweils an der gleichen Position der Meßstrecke erfolgt.

10. Verfahren nach einem der vorhergehenden Ansprüche, **dadurch gekennzeichnet, daß** als Verzögerungselemente Inverter verwendet werden.

11. Verfahren nach einem der Ansprüche 1 bis 9, **dadurch gekennzeichnet, daß** als Verzögerungselemente Buffer verwendet werden.

12. Verfahren nach einem der vorhergehenden Ansprüche, **dadurch gekennzeichnet, daß** dieses in einer Schnellschnittstelle eines Datennetzwerkes durchgeführt wird.
